# EUROPEAN PATENT APPLICATION

(11) **EP 3 557 615 A1**
(43) Date of publication of application: **23.10.2019**
(21) Application number: 17902666.1
(22) Date of filing: 21.06.2017
(51) Int. Cl.: H01L 25/075

(54) **INTEGRATED-TYPE RGB-LED DISPLAY SCREEN**

(30) Priority: 28.03.2017 CN 201710194307
(71) Applicant: Shandong Prosperous Star Optoelectronics Co., Ltd, Tai'an, Shandong 271200 (CN)
(72) Inventor: LI, Shaoli, Tai'an Shandong 271200 (CN); KONG, Yiping, Tai'an Shandong 271200 (CN); YUAN, Xincheng, Tai'an Shandong 271200 (CN)
(74) Representative: Cabinet Chaillot
(86) International application number: PCT/CN2017/089334
(87) International publication number: WO 2018/176655

(57) **Abstract**

The present invention provides an integrated RGB LED display screen, comprising a printed circuit board (PCB) and a plurality of RGB LED packaging modules welded on the PCB, wherein each packaging module comprises a packaging holder and light emitting units arranged on the packaging holder, the number of the light emitting units is at least two, and each group of light emitting units comprises a group of RGB LED chips. The integrated RGB LED display screen provided by the present invention has the advantages that a plurality of light emitting units is integrated on one packaging module, thereby further improving the production efficiency and reducing the production cost. In addition, the plurality of light emitting units is integrated on one packaging module, which can effectively improve the overall resistance of the display screen to the external mechanical strength.

## Description

### Technical Field

The present invention relates to an SMD (Surface Mounted Devices) LED packaging technology, and more particularly relates to an integrated RGB LED display screen.

### Background Art

With continuous development of the display screen industry, LEDs for display screens are rapidly transformed from original DIP (dual inline-pin package) structures to SMD structures. The LEDs of the SMD structures have been increasingly accepted by users due to the advantages of light weight, smaller size, automatic installation, large illumination angle, uniform color, little attenuation and the like. Although the general SMD LEDs have the above advantages, however, problems of large attenuation, long heat conduction path, low carrying current, complicated production, low reliability, low water vapor resistance and poor weather resistance still exist. If the reliability of a product is to be improved without changing the overall structure of the product, there is still no good solution in the industry.

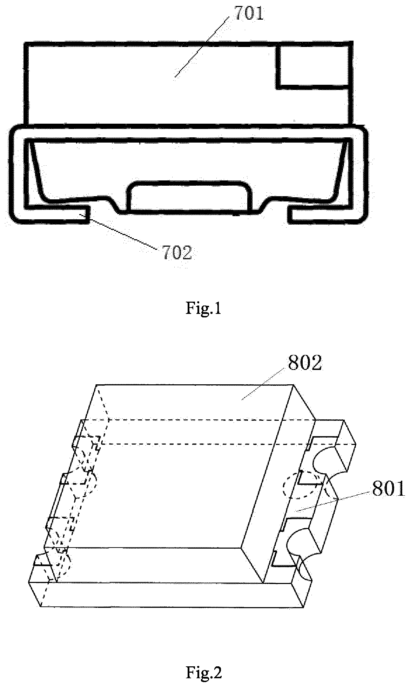

Packaging devices of 2121, 1515, 1010, 0808 and other types are mainly used in the existing small-pitch LED display screens. With the reduction of pixel pitches of LED display screens, more and more packaging devices are on per unit area, so that the proportion of the cost of the packaging devices in the cost of the whole screen is on the rise. By estimation, the proportion of the cost of the packaging devices has reached 70% or above in small-pitch LED display screens P1.9 and smaller-pitch products. If the density is increased by one level, the increase in bead demand is about 50%, that is, the production capacity of all bead manufacturers needs to increase by 50% or above. At present, full-color beads used for small pitches are mainly in a single form (as shown in Figure 1 and Figure 2). Due to the large number of beads in applications, the production efficiency is low, and quality problems are easily caused. For the single-mount problem, the production efficiency is improved to certain extent by using a COB (chip on board) integrated module. However, the COB integrated module also has many problems, such as color development difference and poor entire screen consistency caused by center value differences of different batches of chips or substrate ink differences. On the other hand, the chip directly mounted on the circuit board is not well protected such that the reliability cannot be guaranteed, and the failure maintenance cost of the light emitting unit is high.

Therefore, the prior art has yet to be improved and developed.

### Summary of the Invention

The present invention is directed to provide an integrated RGB LED display screen, aiming at solving the problems of low production efficiency, poor mechanical strength, poor heat dissipation performance and the like of the existing RGB LED display screens.

To solve the above problems, the technical scheme of the present invention is as follows:
An integrated RGB LED display screen, comprising a printed circuit board (PCB) and a plurality of RGB LED packaging modules welded on the PCB, wherein each packaging module comprises a packaging holder and light emitting units arranged on the packaging holder, the number of the light emitting units is at least two, and each group of light emitting units comprises a group of RGB LED chips.

The integrated RGB LED display screen, wherein the packaging holder comprises a metal baseboard and an insulating frame, holder electrodes for die bond and wire weld are arranged on the metal baseboard at a region where each light emitting unit is located; each light emitting unit comprises RGB LED chips fixed on the metal baseboard as well as keys and wires for connecting the RGB LED chips with the holder electrodes, and the holder electrodes are electrically connected with the PCB by pads arranged on the back of the metal baseboard.

The integrated RGB LED display screen, wherein the insulating frame can be arranged around the light emitting units and forms bowl shape.

The integrated RGB LED display screen, wherein steps can be set on the front side and/or the reverse side of the metal baseboard.

The integrated RGB LED display screen, wherein support regions, being flush with the pads in height, can be further set on the metal baseboard.

The integrated RGB LED display screen, wherein the support regions can be circular, square or irregular support structures.

The integrated RGB LED display screen, wherein a protective layer can be arranged on the light emitting units.

The integrated RGB LED display screen, wherein the surface of the protective layer can be rough and non-reflective.

The integrated RGB LED display screen, wherein the bowls can have the height of 0.2-0.8 mm.

The integrated RGB LED display screen, wherein the number of the steps can be at least one.

The integrated RGB LED display screen according to the present invention has the beneficial effects: a plurality of light emitting units is integrated on one packaging module, thereby further improving the production efficiency and reducing the production cost. In addition, the plurality of light emitting units is integrated on one packaging module, which can effectively improve the overall resistance of the display screen to the external mechanical strength; compared with the existing integrated module, one packaging module of the present invention comprises fewer light emitting units, which can effectively avoid the problems of color development difference and poor entire screen consistency caused by center value differences of different batches of chips or substrate ink differences; and the existing integrated module is high in maintenance cost if some light emitting units fail, but the present invention is low in maintenance cost. On the other hand, the metal baseboard is used to replace conventional plated thin metal, thereby enhancing the conductivity; the metal baseboard is directly in contact with the PCB, so the heat dissipation path is short, and the heat of the chips can be quickly exported; light is concentrated by forming the bowl-type structures on the front side, so that the light emitting surface is unique, and the resolution, light-dark contrast and the like of the LED display screen are superior.

### Brief Description of the Drawings

Figure 1 is a structure diagram of a conventional PPA holder.
Figure 2 is a structure diagram of a conventional CHIP type packaging holder.
Figure 3 is a front structure diagram of an integrated RGB LED display screen according to the present invention.
Figure 4 is a front partial enlarged view of the integrated RGB LED display screen according to the present invention.
Figure 5 is a front structure diagram of a packaging module of the integrated RGB LED display screen according to the present invention.
Figure 6 is a cross-sectional view of the packaging module of the integrated RGB LED display screen according to the present invention.
Figure 7 is a reverse structure diagram of the packaging module of the integrated RGB LED display screen according to the present invention.
Figure 8 is a front structure diagram of a packaging module of a 1×2 integrated RGB LED display screen according to the present invention.
Figure 9 is a front structure diagram of a packaging module of a 1×3 integrated RGB LED display screen according to the present invention.
Figure 10 is a front structure diagram of a packaging module of a 1×3 integrated RGB LED display screen according to the present invention.
Figure 11 is a front structure diagram of a packaging module of a 1×9 integrated RGB LED display screen according to the present invention.
Figure 12 is a front structure diagram of a metal baseboard of a packaging module of a 1×4 integrated RGB LED display screen according to the present invention.
Figure 13 is a reverse structure diagram of a metal baseboard of a packaging module of a 1×4 integrated RGB LED display screen according to the present invention.
Figure 14 is a front structure diagram of a non-cut metal baseboard of a packaging module of a 1×4 integrated RGB LED display screen according to the present invention.

Indication for drawing reference: 1. RGB LED display screen; 2. packaging module; 100. metal baseboard; 101. holder electrode; 102. pad; 103. step; 104. support region; 200. insulating frame; 201. bowl; 301. RGB LED chip; 302. key and wire; 400. protective layer; 701. thermoplastic material; 702. metal; 801. resin; 802. flat glue.

### Detailed Description of the Invention

For the purpose of making objectives, technical schemes and advantages of the present invention clearer, the following further describes the present invention in detail with reference to the accompanying drawings and embodiments.

Figure 1 is a structure diagram of a conventional PPA+ copper lead packaging holder. Since a thermoplastic material in this type of packaging holder is tightly attached to the metal by an injection molding machine but not bonded to the metal, a gap is easily set between the two during thermal expansion and cold contraction. When a terminal customer uses the product, ambient water and water vapor easily enter the package through the gap, causing product failure. Figure 2 is a structure diagram of a conventional CHIP type packaging holder, which is obtained by surrounding and compacting glass fibers with resin 801, and then etching circuits with copper and platinum, where the gap and moisture absorption rate of the materials are high, and the expansion rates of the materials are different. A layer of flat glue 802 is die-pressed on a plane as a protective layer in the later stage. A cup-shaped protection cannot be set in this way, and many problems will be caused. On the other hand, the products shown in Figure 1 and Figure 2 are in a single form, and the production efficiency is extremely low when being mounted later.

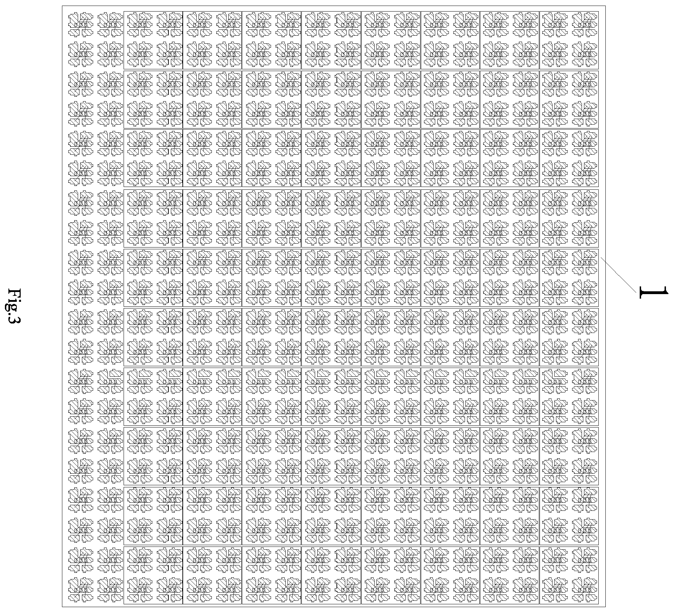

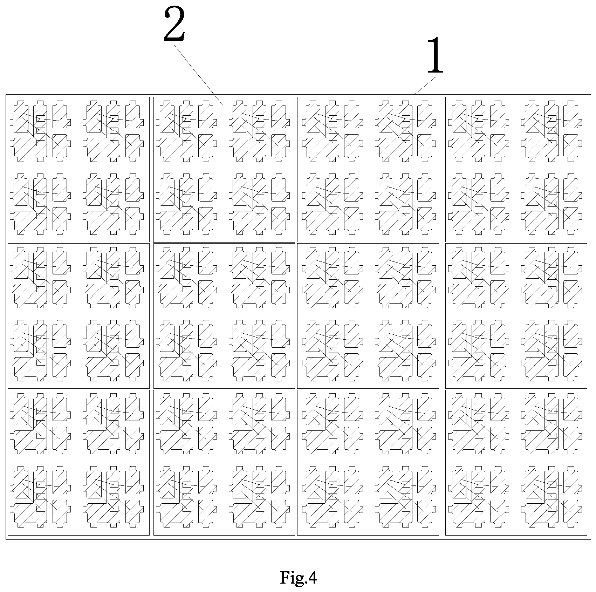

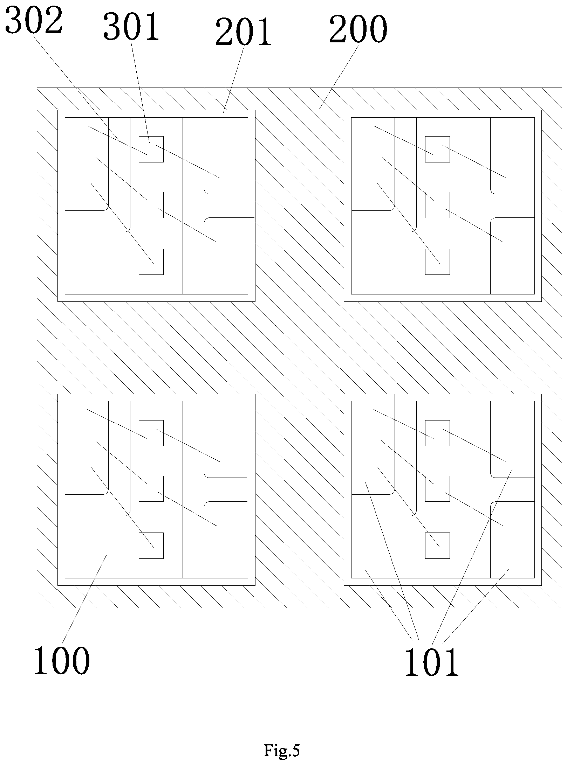

Referring to Figure 3 and Figure 4, an integrated RGB LED display screen 1 according to the present invention includes a PCB and a plurality of RGB LED packaging modules 2 welded on the PCB. Referring to Figure 5 to Figure 7, each packaging module 2 includes a packaging holder and light emitting units arranged on the packaging holder, the number of the light emitting units is at least two, and each group of light emitting units includes a group of RGB LED chips 301. Preferably, the number of the light emitting units can be 2-16 and is 4 in the present embodiment. The packaging holder includes metal baseboards 100 and insulating frames 200. In practical applications, the material of the metal baseboard 100 may be copper or iron. Preferably, the surface of the metal baseboard is plated with gold or silver to enhance the conductivity and facilitate welding. The material of the insulating frame may be epoxy resin, PPA, PCT or the like, and is epoxy resin in the present embodiment. Holder electrodes 101 for die bond and wire weld are arranged at a region where each light emitting unit is located on the metal baseboard 100. In a practical application, the number of the holder electrodes 101 is four, and the holder electrodes 101 are set by the metal baseboard 100 through etching or stamping. Each light emitting unit includes RGB LED chips 301 fixed on the metal baseboard as well as keys and wires 302 for connecting the RGB LED chips with the holder electrodes, a protective layer 400 is arranged on the light emitting units, and the holder electrodes relate to an external circuit by pads 102 arranged on the back of the metal baseboard 100. The metal baseboard 100 is directly in contact with a PCB, so that the heat dissipation path is short, and the heat of the chips can be quickly exported. As the number of packaging devices on per unit area of an LED display increases, if the density is increased by one level, the amount of generated heat is huge, and the structure of the present invention can discharge the heat very efficiently. On the other hand, the packaging module of the present invention has a plurality of light emitting units, the mounting efficiency of which is improved by N times compared with single beads (N is the number of lights emitting units on the packaging module).

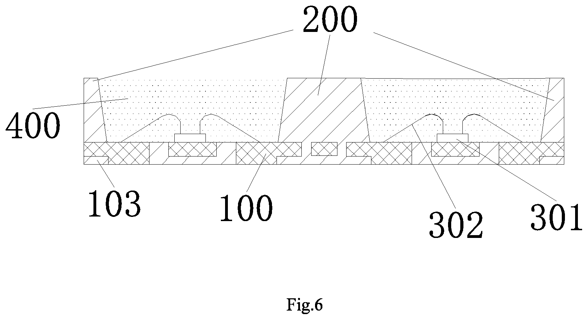

Referring to Figure 6, bowls 201 are set around the light emitting units by the insulating frame 200. Through the arrangement of the bowls 201, the light of RGB LEDs can be more concentrated, and the light emitting surface is unique, so that the influence of other surrounding light emitting units is avoided, and the resolution, light-dark contrast and the like of a manufactured display screen are superior. At the same time, the arrangement of the bowls 201 further enhances the mechanical protection on the light emitting units and avoids the problem of falling of the surface protective layer due to the external force. Preferably, the bowls 201 have the height of 0.2-0.8 mm.

In actual production, referring to Figure 6, steps 103 are set on the metal baseboard 100 to reinforce the tightness and stability of combination of the metal baseboard 100 and the insulating frame 200, prevent the ingress of water and water vapor, and further improve the mechanical strength of the module. Preferably, the steps 103 are set on the front side, the reverse side or both the front and reverse sides of the metal baseboard 100. The number of the steps 103 is at least one. Preferably, the steps 103 are on the front and reverse sides of the metal baseboard 100.

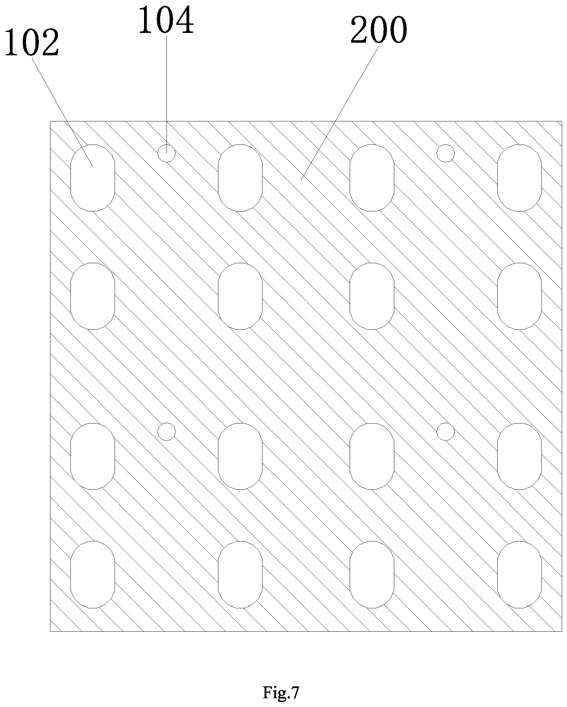

Referring to Figure 7, in actual production, support regions 104, being flush with the pads 102 in height, are further set on the metal baseboard 100. The arrangement of the support regions 104 can ensure the flatness of the metal baseboard 100 during the manufacturing process of the packaging module and prevent the metal baseboard 100 from being deformed or tilting when the insulating frame is die-pressed. Preferably, the support regions 104 may be circular, square or other irregular support regions or support pillars. The number of the support regions 104 may be one or plural, which is not further defined in the present invention.

Referring to Figure 6, preferably, the surface of the protective layer 400 is rough and non-reflective. Further, the protective layer 400 is a translucent epoxy resin layer with a diffusing agent. The protective layer 400 is seamlessly combined with the bowls 201 to further prevent the ingress of water and water vapor, and the waterproof effect is much better than that of conventional metal and plastic bonding. On the other hand, the surface of the protective layer 400 is rough and non-reflective, which reduces the influence of external light. Further, the translucent epoxy resin layer with the diffusing agent is combined with the bowls 201 to form an optical lens, so that the LED light is more concentrated.

In actual production, the protective layer 400 is set by injecting liquid glue into the cavities of the bowls 201 by dispensing or filling. Preferably, a translucent epoxy resin glue with a diffusing agent is selected and cured by heating preferably at 100-300 degrees Celsius. In this way, a full bowl protective layer is set. The protective layer 400 is flush with the bowls 201 in height, the height of the bowls 201 can be 0.5-0.7 mm, and the protective layer 400 made in this way is more stable.

The glue injection method may also be pressing the glue into the cavities of the bowls 201 through a designed MGP mold, and the glue is liquid glue or solid glue cakes. In this way, a half bowl protective layer is set, the bowls 201 are slightly lower than the protective layer 400 in height, the height of the bowls 201 is 0.3-0.5 mm, and the protective layer supported in this way is low in cost.

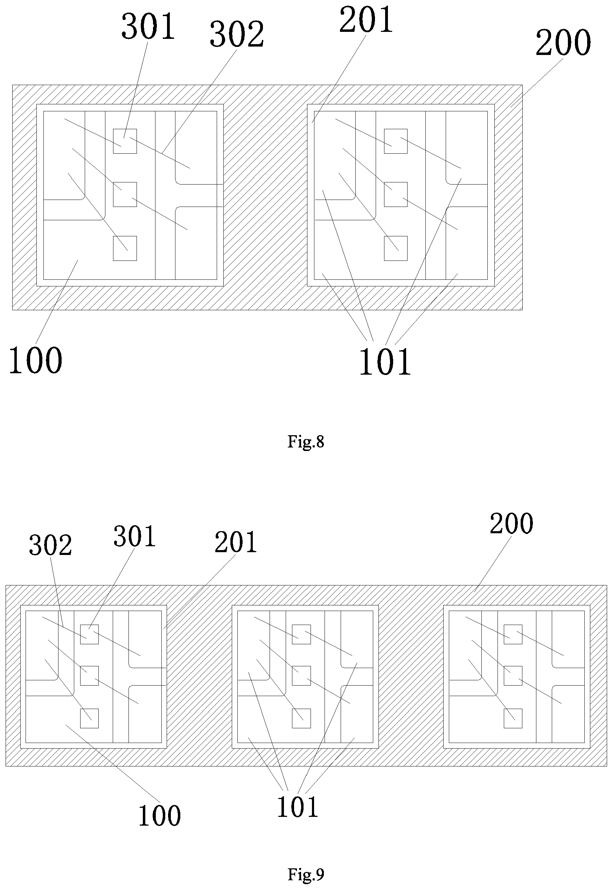

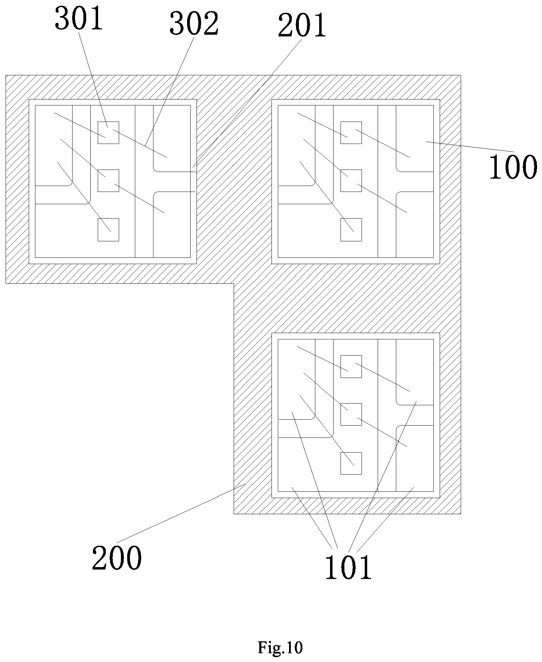

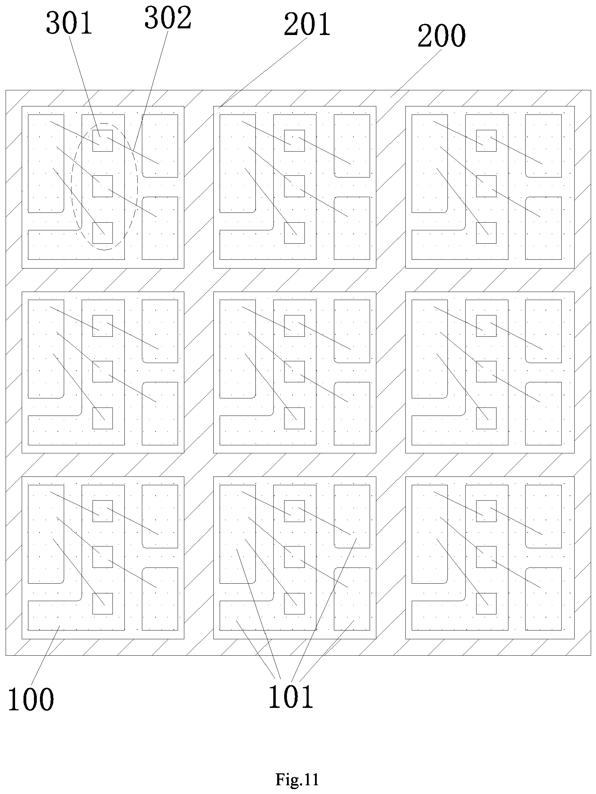

Figure 8 to Figure 11 show embodiments of packaging modules having different numbers of light emitting units according to the present invention. The number of lights emitting units is two in Figure 8, three in Figure 9, and nine in Figure 11. In the present invention, the number of the light emitting units is at least two, preferably 2-16. Referring to Figure 10, the light emitting units may also be arranged in an inverted "L" shape. The arrangement of the light emitting units is not limited in the present invention, and may be an "-" arrangement, or a combination of rows and columns of MxN (M and N are integers), or other irregular arrangement, and the present invention is not limited thereto. It should be noted that modifications or changes could be made by those of ordinary skill in the art according to the above description, and all these modifications or changes shall fall within the scope of the appended claims of the present invention.

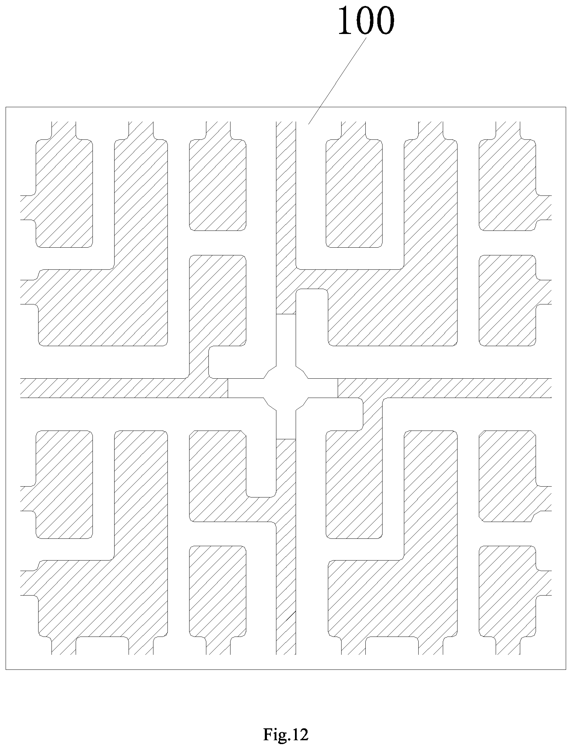

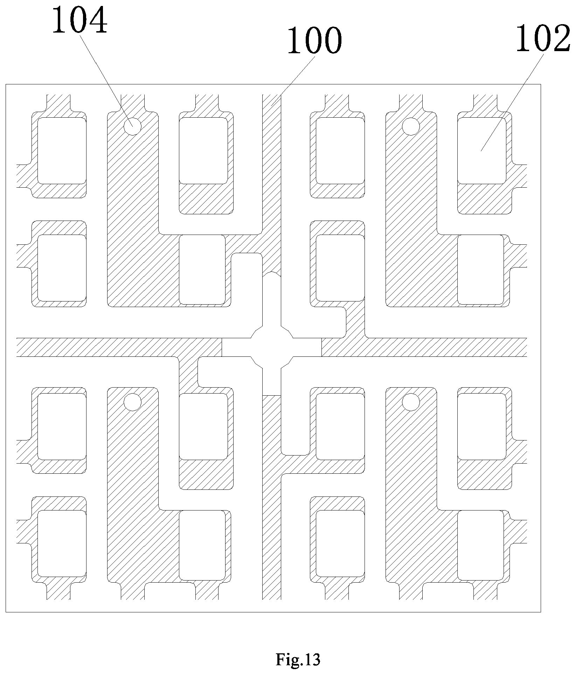

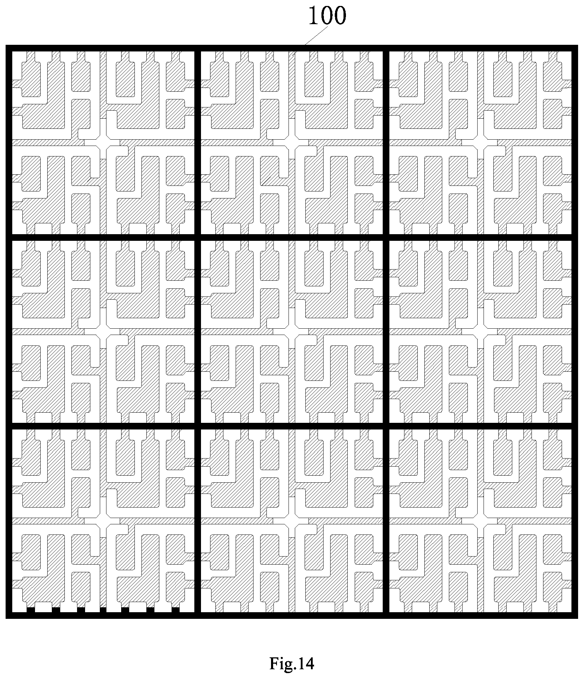

Figure 12 to Figure 14 are structure diagrams of a metal baseboard 100 of a 1x4 packaging module (i.e., one packaging module having four light emitting units) according to the present invention. In actual production, the holder electrodes 101 need to be independent from each other, otherwise, short circuit is caused. If the holder electrodes 101 are to be plated, all the holder electrodes 101 must be connected. In the present invention, the metal baseboard 100 is firstly made into conductive circuits. At this time, all the holder electrodes 101 are connected. After electroplating, the metal baseboard 100 is cut with a cutting machine, and all the holder electrodes 101 are disconnected at the joints, thereby solving the above problem. Referring to Figure 14, for the case where the packaging module has different numbers of light emitting units, the joints of all the holder electrodes 101 can be set at the cutting positions of the cutting machine, to ensure that the joints of all the holder electrodes 101 are cut off during cutting. It should be noted that the connection direction of the holder electrodes 101 and the specific shape and circuits etched or stamped on the metal baseboard 100 are not limited in the present invention, modifications or changes could be made by those of ordinary skill in the art according to the above description, and all these modifications or changes shall fall within the scope of the appended claims of the present invention.

A manufacturing process of the integrated RGB LED display screen according to the present invention includes the following steps:
step 1: making a metal baseboard 100 into conductive circuits by etching or stamping;
step 2: coating glue on the metal baseboard 100 by a molding press, and leaving blank holder electrodes 101 for die bond and wire weld to form a packaging holder;
step 3: plating a metal on the holder electrodes 101;
step 4: die-bonding RGB LED chips 301 onto the holder electrodes, and welding wires to form a physical electrical connection;
step 5: forming a protective layer 400 on light emitting units by injection molding;
step 6: cutting into single packaging modules with a cutting machine; and
step 7: mounting the packaging modules to a PCB to form the RGB LED display screen.

It should be understood that the application of the present invention is not limited to the above examples, modifications or changes may be made by those of ordinary skill in the art according to the above description, and all these modifications and changes shall fall within the scope of the appended claims of the present invention.

## Claims

1. An integrated RGB LED display screen, comprising a PCB and a plurality of RGB LED packaging modules welded on the PCB, wherein the packaging modules comprise packaging holders and light emitting units arranged on the packaging holders; the number of the light emitting units is at least two, and each group of light emitting units comprises a group of RGB LED chips.

2. The integrated RGB LED display screen according to claim 1, wherein the packaging holder comprises a metal baseboard and an insulating frame; holder electrodes for die bond and wire weld are arranged on the metal baseboard at a region where each light emitting unit is located; each light emitting unit comprises RGB LED chips fixed on the metal baseboard as well as keys and wires for connecting the RGB LED chips with the holder electrodes, and the holder electrodes are electrically connected with the PCB by pads arranged on the back of the metal baseboard.

3. The integrated RGB LED display screen according to claim 2, wherein the insulating frame are arranged around the light emitting units and forms bowl shape.

4. The integrated RGB LED display screen according to claim 2, wherein steps are set on the front side and/or the reverse side of the metal baseboard.

5. The integrated RGB LED display screen according to claim 2, wherein support regions, being flush with the pads in height, are further set on the metal baseboard.

6. The integrated RGB LED display screen according to claim 5, wherein the support regions are circular, square or irregular support structures.

7. The integrated RGB LED display screen according to claim 2, wherein a protective layer is arranged on the light emitting units.

8. The integrated RGB LED display screen according to claim 7, wherein the surface of the protective layer is rough and non-reflective.

9. The integrated RGB LED display screen according to claim 3, wherein the bowls have the height of 0.2-0.8 mm.

10. The integrated RGB LED display screen according to claim 4, wherein the number of the steps is at least one.
